# EUROPÄISCHE PATENTSCHRIFT

(11) **EP 2 612 410 B1**
(45) Veröffentlichungstag und Bekanntmachung des Hinweises auf die Patenterteilung: **13.04.2016**
(21) Anmeldenummer: 11751541.1
(22) Anmeldetag: 06.08.2011
(51) Int. Cl.: G01R 31/04, H02H 7/20, H02S 50/10, H02H 1/00

(54) **VERFAHREN UND VORRICHTUNG ZUM SICHEREN SCHALTEN EINER PHOTOVOLTAIKANLAGE NACH UNTERSCHEIDUNG DER LICHTBOGENART**
METHOD AND DEVICE FOR SAFELY SWITCHING A PHOTOVOLTAIC SYSTEM AFTER DIFFERENTIATING THE ARC TYPE
PROCÉDÉ ET DISPOSITIF DE COMMUTATION SÛRE D'UN SYSTÈME PHOTOVOLTAÏQUE APRÈS DIFFÉRENCIATION DU TYPE D'ARC ÉLECTRIQUE

(30) Priorität: 08.01.2011 DE 102011008140; 31.08.2010 DE 102010035960
(43) Veröffentlichungstag der Anmeldung: 10.07.2013
(73) Patentinhaber: Ellenberger & Poensgen GmbH, 90518 Altdorf (DE)
(72) Erfinder: STROBL, Christian, 90419 Nürnberg (DE); MIKLIS, Markus, 90592 Pfeifferhütte (DE)
(74) Vertreter: FDST Patentanwälte
(86) Internationale Anmeldenummer: PCT/EP2011/003955
(87) Internationale Veröffentlichungsnummer: WO 2012/028247

(56) Entgegenhaltungen:
- WO-A1-95/25374
- WO-A1-2005/098458
- WO-A1-2011/017721
- DE-A1-102007 013 712
- US-A1- 2011 019 444
- STROBL C ET AL: "Arc Faults in Photovoltaic Systems", ELECTRICAL CONTACTS (HOLM), 2010 PROCEEDINGS OF THE 56TH IEEE HOLM CONFERENCE ON, IEEE, PISCATAWAY, NJ, USA, 4. Oktober 2010 (2010-10-04), Seiten 1-7, XP031788250, ISBN: 978-1-4244-8174-3

## Beschreibung

Die Erfindung betrifft ein Verfahren und eine Vorrichtung zum sicheren Schalten einer Gleichspannungsanlage im Falle eines gleichstromseitig auftretenden Lichtbogens gemäß dem Oberbegriff des Anspruchs 1 bzw. des Anspruchs 9. Ein derartiges Verfahren und eine entsprechende Vorrichtung sind aus der WO 95/25374 A1 bekannt. Unter Gleichspannungsanlage wird hier insbesondere eine Photovoltaikanlage verstanden.

Eine Gleichspannungsanlage der genannten Art kann auch als Niederspannungsanlage für Gleichspannungen bis beispielsweise 1000 V Gleichspannung bezeichnet werden. Eine derartige Anlage ist beispielsweise eine Batterieanlage, eine Anlage mit Brennstoffzellen, eine elektrische Anlage in einem Kraftfahrzeug, insbesondere in einem Elektro- oder Hybridfahrzeug, und eine Photovoltaikanlage mit üblicherweise einer Anzahl von Gleichstromerzeugem.

Eine Photovoltaikanlage als Gleichstromanlage umfasst üblicherweise eine Anzahl von Photovoltaikmodulen (panels), die in so genannten Strings in Reihe geschaltet sind. Auch können mehrere Strings parallel geschaltet werden, so dass ein Photovoltaikgenerator mit mehreren Photovoltaikmodulen und einem oder mehreren Strings gebildet ist. Hierbei bestimmt prinzipiell die Anzahl der Module (Panels) innerhalb eines Strings die generierte Gleichspannung, während durch die Anzahl der parallel geschalteten Strings der Gleichstrom des Photovoltaikgenerators bestimmt wird.

Dient die Photovoltaikanlage zur Einspeisung von aus Sonnenenergie gewandelter elektrischer Energie in ein öffentliches Stromnetz, so wird üblicherweise ein Wechselrichter eingesetzt, der den in den Photovoltaikmodulen entstehenden Gleichstrom in Wechselstrom mit einer an die Netzfrequenz angepassten Wechselstromfrequenz wandelt. Im Falle einer netzfernen Gleichspannungs- bzw.

Photovoltaikanlage kann die erzeugte Energie zwischengespeichert oder direkt zur Lastversorgung verwendet werden.

Der Wechselrichter oder allgemein ein Wandler sorgt in Verbindung mit einer so genannten Leistungsführung (maximum power point tracker) dafür, dass die Last bzw. der Verbraucher stets im oder zumindest in der Nähe des so genannten maximalen Leistungspunktes (maximum power point) arbeitet. Die sich gemäß der charakteristischen I-U-Kennlinie einer Photovoltaikanlage aus dem Produkt der Gleichspannung und dem Gleichstrom bestimmende Leistung der Photovoltaikanlage ist im Leerlauf (I_{DC} = 0) sowie im Kurzschlussfall (U_{DC} = 0) Null, d.h. in diesen Extremfällen gibt die Photovoltaikanlage keine Leistung ab. Im Punkt MPP wird die von den Solarzellen und damit von den Photovoltaikmodulen abgegebene Leistung maximal. Die Lage dieses maximalen Leistungspunktes (Arbeitspunkt) ist von verschiedenen Faktoren, wie insbesondere der Sonneneinstrahlung, der Temperatur und Alterungserscheinungen abhängig. Eine MPPT-Schaltung zur (maximalen) Leistungsführung stellt den Gleichstrom und die Gleichspannung des Photovoltaikgenerators auf den der maximalen Leistung entsprechenden Arbeitspunkt ein.

In einer derartigen Gleichstromanlage und somit auch in einer Photovoltaikanlage können je nach Anlagenarchitektur sowie in Folge von gealterten oder geschädigten Leitungsverbindungen oder Kabeln und in Folge beschädigter Module Lichtbögen an unterschiedlichen Orten und mit unterschiedlicher Leistung auftreten. Um einen von einem Kurzschluss bzw. einer Strompfadunterbrechung begleiteten Lichtbogen zu erkennen, ist es aus der WO 95/25374 bekannt, die vom Lichtbogen ausgehende elektromagnetische Strahlung zu detektieren und zum Schutz der Anlage den den Kurzschluss bzw. die Strompfadunterbrechung aufweisenden Schaltungsteilbereich sicher zu schalten.

Der Erfindung liegt die Aufgabe zugrunde, ein besonders geeignetes Verfahren zum sicheren Schalten einer derartigen Gleichstromanlage, insbesondere einer Photovoltaikanlage, im Falle eines auftretenden Lichtbogens anzugeben. Des Weiteren soll eine zur Durchführung des Verfahrens geeignete Vorrichtung angegeben werden.

Bezüglich des Verfahrens wird die Aufgabe erfindungsgemäß gelöst durch die Merkmale des Anspruchs 1. Vorteilhafte Weiterbildungen sind Gegenstand der hierauf rückbezogenen Unteransprüche.

Hierzu wird im Falle eines sensorisch erfassten Lichtbogens die Leistungsführung der Anlage bzw. des Verbrauchers (Last) verstellt und eine Leistungsänderung des Lichtbogens erfasst. Im Falle einer durch die Leistungsverstellung bedingten Leistungsabnahme des Lichtbogens wird in Abhängigkeit von der Verstellrichtung der Leistungsführung auf einen seriellen oder auf einen parallelen Lichtbogen erkannt. Dabei wird bei einem seriellen Lichtbogen eine Gleichstromunterbrechung initiiert und bei einem parallelen Lichtbogen ein Kurzschlussstrom erzeugt, d.h. ein Kurzschluss bewußt erzwungen.

In zweckmäßiger Ausgestaltung wird die Leistungsführung in Leerlaufrichtung, also in Richtung zunehmender Gleichspannung, um einen Verstellbetrag verstellt und eine Leistungsänderung des Lichtbogens erfasst. Diese Verstellrichtung wird bevorzugt, wenn aufgrund ausreichend aussagekräftiger Sensordaten bereits eine zumindest grobe Qualifizierung der Art des Lichtbogens als serieller Lichtbogen möglich ist. Anderenfalls, wenn die Sensordaten den Lichtbogen mit überwiegender Wahrscheinlichkeit als parallele Lichtbogen klassifizieren, erfolgt eine Verstellung der Leistungsführung bzw. des Strom-Spannungs- oder Leistungs-Spannungs-Arbeitspunktes in Kurzschlussrichtung. Wird in Folge der Verstellung der Leistungsführung eine Leistungsabnahme, z.B. ein Verlöschen des Lichtbogens festgestellt, so wird je nach vorheriger Verstellrichtung der Leistungsführung auf einen seriellen bzw. auf einen parallelen Lichtbogen erkannt. Anderenfalls, also im Falle keiner Leistungsänderung oder einer Leistungszunahme des Lichtbogens, wird die Leistungsführung zunächst um den Verstellbetrag zurückgestellt und anschließend in die jeweils entgegengesetzte Verstellrichtung um einen Verstellbetrag verschoben.

Die Erfindung geht dabei von der Erkenntnis aus, dass eine zuverlässige Sicherschaltung einer Gleichspannungs- bzw. Photovoltaikanlage dann gegeben ist, wenn durch die eingeleitete Schutzmaßnahme ein Verlöschen des Lichtbogens auch gewährleistet ist. So muss erkanntermaßen bei einem seriellen Lichtbogen die Last bzw. der Wechselrichter vom Gleichspannungsgenerator getrennt und somit abgeschaltet werden, um den Lichtbogen zu unterbrechen bzw. zu löschen. Wird nämlich bei einem parallelen Lichtbogen die Last bzw. der Wechselrichter in Folge einer solchen Trennschaltung vom Gleichstromgenerator abgeschaltet, so verbleibt lediglich der Lichtbogen als Last mit der Folge, dass der gesamte verbleibende Gleichstrom über den Lichtbogen fließt und diesen entsprechend ver stärkt und gerade nicht löscht.

Daher ist bei einem parallelen Lichtbogen der Wechselrichter bzw. die Last gleichstromseitig kurzzuschließen. Da nun erkanntermaßen der überwiegende Teil möglicher Lichtbögen in serielle Lichtbögen einerseits und in parallele Lichtbögen andererseits klassifiziert werden kann, sollte zunächst ein erfasster Lichtbogen als serieller oder paralleler Lichtbogen identifiziert werden, was sensorisch nur äußerst schwierig oder aber nur mit erheblichem sensorischem Aufwand möglich wäre.

Die Erfindung geht aufgrund dieser Erkenntnisse nun von der Überlegung aus, dass das Leistungsverhalten eines auftretenden Lichtbogens in einer derartigen Anlage sensorisch zunächst unabhängig von der Lichtbogenart (seriell oder parallel) in einfacher Weise erfasst werden kann, während dann die Identifizierung der Lichtbogenart unabhängig vom Sensor durch einen gesteuerten Eingriff in die Leistungsführung ermöglicht wird. Wird nämlich der Arbeitspunkt, d.h. die Leistungsführung in Leerlaufrichtung verstellt (verstimmt) und nimmt in Folge dessen die Lichtbogenleistung ab, so kann zuverlässig auf einen seriellen Lichtbogen geschlossen werden. Analog kann bei einer gezielten Verstellung der Leistungsführung bzw. des Arbeitspunktes und einer dadurch bedingten, sensorisch erfassten Leistungsabnahme des Lichtbogens zuverlässig auf einen parallelen Lichtbogen geschlossen werden.

Die Identifizierung als serieller oder paralleler Lichtbogen bildet dann das Steuerkriterium für beispielsweise einen Trennschalter in der gleichstromseitigen Strombahn bzw. zur Steuerung eines gleichstromseitigen Kurzschlussschalters zur Last bzw. zum Wechselrichter oder Wandler in dessen Schließstellung. Bei entsprechend ausgebildeten Wechselrichtern bzw. Wandlern können diese Kurzschlussschalter- und Trennschalterfunktionen auch in die Wechselrichter bzw. Wandlerfunktion durch entsprechende elektronische Schaltungsmaßnahmen integriert sein.

Bezüglich der Vorrichtung wird die Aufgabe erfindungsgemäß gelöst durch die Merkmale des Anspruchs 6. Vorteilhafte Ausgestaltungen sind Gegenstand der hierauf rückbezogenen Unteransprüche.

Dazu umfasst die Vorrichtung eine Steuerung zur Leistungsführung bzw. zur Verstellung oder Einstellung des Arbeitspunktes der Anlage. Einem Wandler ist gleichstromseitig mindestens ein Lichtbogensensor vorgeschaltet, der mit der Steuerung verbunden ist. Bei dem Wandler kann es sich je nach Art der Gleichstromanlage um einen Wechselrichter (DC-AC-Wandler), einen DC-DC-Wandler, einen Laderegler oder dergleichen handeln.

Mittels der Steuerung erfolgt eine Verstellung der Leistungsführung, wenn ein Lichtbogen sensorisch erfasst ist. Die Steuerung klassifiziert anhand der erfassten Leistungsänderung des Lichtbogens und in Abhängigkeit von der Verstellrichtung der Leistungsführung den Lichtbogen als seriellen oder parallelen Lichtbogen. Bei einer Klassifizierung als serieller Lichtbogen bewirkt die Steuerung eine gleichstromseitige Trennung und bei einer Klassifizierung als paralleler Lichtbogen ein gleichstromseitiges Kurzschließen des Wandlers.

Zur Sicherschaltung der Anlage ist geeigneterweise ein dem Wandler seriell vorgeschalteter Trennschalter und ein dem Wandler parallel geschalteter Kurzschlussschalter vorgesehen, welche Schalter mit einem Steuerausgang der Steuerung verbunden sind. Im Falle eines seriellen Lichtbogens steuert die Steuerung den Trennschalter in dessen Offenstellung, während im Falle eines parallelen Lichtbogens die Steuerung des Kurzschlussschalters in dessen Schließstellung steuert. Die Verstellung der Leistungsführung bzw. des Arbeitspunktes kann, insbesondere im Falle eines Wechselrichters, durch eine Impedanzänderung erfolgen.

Nachfolgend wird ein Ausführungsbeispiel der Erfindung anhand einer Zeichnung näher erläutert. Darin zeigen:
- Fig. 1: schematisch eine Photovoltaikanlage mit einer Anzahl von in Strings verschalteten Photovoltaikmodulen und mit einem gleichstromseitigen Sensor sowie mit einem Wechselrichter mit gleichstromseitiger Steuerung zur Leistungsführung, und
- Fig. 2: eine lichtbogenspezifisch verstellbare I-U- und P-U-Kennlinie der Steuerung zur Leistungsführung.

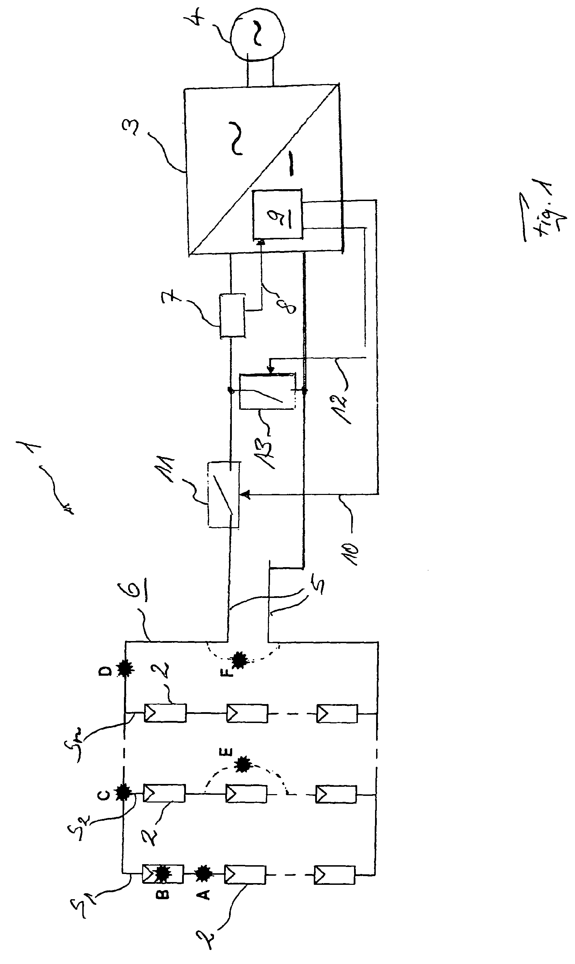

Fig. 1 zeigt schematisch eine Photovoltaikanlage 1 mit einer Anzahl von Photovoltaikmodulen 2, die mit Beipassdioden versehen sein können und zu mehreren Strings Sₙ verschaltet sind. Die Strings Sₙ sind an einen gemeinsamen Wechselrichter 3 angeschlossen, der den von den Photovoltaikmodulen 2 erzeugten Gleichstrom in Wechselstrom wandelt und diesen in ein (öffentliches) Stromnetz 4 einspeist. Gleichstromseitig ist eine Zuleitung 5 zwischen den den Photovoltaikgenerator 6 bildenden, seriell bzw. parallel verschalteten Photovoltaikmodulen 2 und dem Wechselrichter 3 ein Lichtbogensensor 7 geschaltet. Die Lichtbogensensor 7 ist ausgangsseitig über eine Signalleitung 8 mit einer Steuerung 9 zur Leistungsführung (MPPT) verbunden, die im Ausführungsbeispiel dem Wechselrichter 3 zugeordnet ist. Die Steuerung 9 ist ausgangsseitig über eine erste Steuerleitung 10 mit einem Trennschalter 11 verbunden, der in die Zuleitung 5 seriell eingeschaltet ist. Über eine zweite Steuerleitung 12 ist die Steuerung 9 mit einem Kurzschlussschalter 13 verbunden, der gleichstromseitig parallel zum Wechselrichter 3 in die Zuleitung 5 geschaltet ist.

Tritt innerhalb der Photovoltaikanlage 1 ein Lichtbogen auf, so wird dieser vom Sensor 7 detektiert und ein entsprechendes Sensorsignal über die Sensorleitung 8 an die Steuerung 9 übermittelt. Bei dem Sensor 7 kann es sich um einen solchen zur Erfassung von insbesondere steilflankigen Stromänderungen handeln, wie dieser aus der WO 2005/098458 A1 bekannt ist. Die Auswertung derartig erfasster schneller Stromänderungen kann innerhalb des Sensors 7 oder auch mittels der Steuerung 9 gemäß dem aus der DE 10 2007 013 712 A1 bekannten Verfahren erfolgen.

Zur Lichtbogendetektierung kann eine Auswertung des (analogen) Sensorsignals auch anhand einer bestimmten Impulsdichte von in Folge eines Lichtbogens generierten Schwellwertüberschreitungen eines 1 bit-Komparators herangezogen werden, wobei eine bestimmte Impulsdichte - also eine bestimmte Anzahl von Impulsen pro Zeiteinheit - festlegt wird, ab der von einem signaltechnisch erfassten Lichtbogen ausgegangen werden kann. Der an sich bereits erfinderische Gedanke besteht darin, ein (analoges) Sensorsignal einer Dichteauswertung der in Folge von Lichtbögen generierbaren Digitalimpulse zu unterziehen und diese rechenzeit- und speicherplatzgünstig mittels eines 1 bit-Komparators anstelle von aufwändigen Mustererkennungen bzw. mehrstelligen bit-Arithmetiken zu erzeugen.

Die Steuerung 9 klassifiziert den Lichtbogen und generiert je nach Lichtbogenart ein Steuersignal zum Trennen der Zuleitung 5. Hierzu liefert die Steuerung 9 über die Steuerleitung 10 ein entsprechendes Signal zum Öffnen des Trennschalters 11. Alternativ generiert die Steuerung 9 ein Steuersignal, das über die Steuerleitung 12 dem Kurzschlussschalter 13 zugeführt wird und diesen in die Schließstellung 13 steuert. Demzufolge wird entweder der Wechselrichter 3 vom Photovoltaikgenerator durch Öffnen des Trennschalters 11 getrennt oder aber durch Schließen des Kurzschlussschalters 13 kurzgeschlossen. Die Art der Sicherschaltung hängt davon ab, ob der Lichtbogen als serieller Lichtbogen oder als paralleler Lichtbogen klassifiziert worden ist.

Bei den in Fig. 1 angedeuteten und mit den Großbuchstaben A bis D bezeichneten Lichtbögen handelt es sich um serielle Lichtbögen, während es sich bei den mit E und F bezeichneten Lichtbögen um parallele Lichtbögen handelt. Ein serieller Lichtbogen tritt beispielsweise innerhalb eines Strings Sₙ (A), in einem Photovoltaikmodul 2 (B), an einer Stringverbindung (C) oder an einer Sammelleitung (D) zum Wechselrichter 3 auf. Ein paralleler Lichtbogen kann zu einem oder mehreren Modulen 2 (E) oder zum Wechselrichter 3 (F) auftreten. Des Weiteren kann jedoch mit wesentlich geringerer Wahrscheinlichkeit ein hier nicht dargestellter Lichtbogen zwischen zwei Strings Sₙ auftreten.

Seriell in den Strings Sₙ oder in der Sammelleitung außer- oder innerhalb des Wechselrichters 3 eingekoppelte Lichtbogensensoren können auch mittels aufwändiger Hochfrequenz-Sensorik im Allgemeinen nicht zwischen seriellen und parallelen Lichtbögen unterscheiden. Auch unter Einbeziehung von hochsensitiven niederfrequenten Stromsensoren kann eine Typisierung des Lichtbogens aufgrund bewölkungsbedingter Quellstrom- und Quellspannungsschwankungen nicht zuverlässig erfolgen, da beispielsweise beim Lichtbogenzünden deutliche Rückströme aus dem üblicherweise vorgesehenen Kondensator des Wechselrichters 3 im Lichtbogenfall F zu beobachten sind. Im Lichtbogenfall E sind zudem lediglich geringe Stromeinbrüche bei Strings Sₙ mit einer großen Anzahl von in Reihe geschalteten Modulen 2 festzustellen. Alternative Konzepte benötigen eine große Anzahl von Spannungssensoren, und zwar grundsätzlich an jedem Modul 2 sowie am Wechselrichter 3, die in einer Zentraleinheit in aufwändiger Art und Weise ausgewertet werden müssten.

Wird dagegen auf einen seriellen Lichtbogen (A bis D) erkannt, so wird dieser durch das Öffnen des Trennschalters 11 - oder eines eventuell vorgesehenen String-Trenners - zum Erlöschen gebracht. Demgegenüber kann bei Erkennung auf einen parallelen Lichtbogen (E, F) durch einen gesteuerten Kurzschluss, der durch Schließen des Kurzschlussschalters 13 hervorgerufen wird, der Lichtbogen am Eingang des Wechselrichters 3 gelöscht werden.

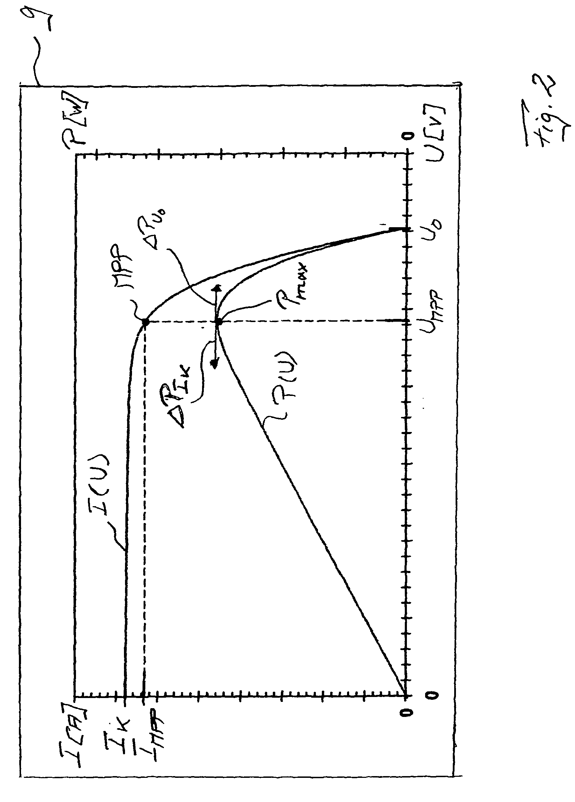

Zur Klassifizierung eines mittels des Sensors 7 detektierten Lichtbogens wird mittels der Steuerung 9 die Leistungsführung des Wechselrichters 3 bzw. des Photovoltaikgenerators 6 gezielt beeinflusst. Hierzu zeigt Fig. 2 in der (oberen) I-U-Kennlinie I (U) den typischen Strom-Spannungs-Verlauf des Photovoltaikgenerators 6. Die (untere) P-U-Kennlinie P(U) zeigt den sich gemäß der Beziehung P=I x U ergebenden Leistungsverlauf des Photovoltaikgenerators 6 in Abhängigkeit von der erzeugten Gleichspannung U.

Erkennbar ist sowohl im Leerlauf U₀, bei dem die Generatorspannung U maximal und der Generatorstrom I gleich Null ist, als auch im Kurzschlussfall Iₖ, bei dem die Generatorspannung U gleich Null und der Kurzschlussstrom I_{K} fließt, die von dem Photovoltaikgenerator 6 abgegebene Leistung P jeweils null (P = 0). In einem bestimmten Punkt, der mit MPP (maximum power point) bezeichnet wird, wird die von dem Photovoltaikgenerator 6 abgegebene Leistung Pₘₐₓ maximal. Die Steuerung 9 zur Leistungsführung, die auch als maximum power point tracking (MPPT) bezeichnet wird, stellt die Leistungsführung und damit den Arbeitspunkt durch entsprechende Steuerung oder Regelung möglichst exakt ein, so dass ein angeschlossener Verbraucher, im vorliegenden Fall der Wechselrichter 3, stets in diesem Arbeitspunkt MPP und somit bei maximaler Leistung Pₘₐₓ arbeitet.

Die Klassifizierung des sensorisch erfassten Lichtbogens als serieller oder paralleler Lichtbogen erfolgt mittels der Steuerung 9 durch eine Verstellung oder Verstimmung der Leistungsführung und damit des Arbeitspunktes MPP bzw. Pₘₐₓ um einen bestimmten Verstellbetrag ΔP_{Uo}, ΔP_{Ik} in Leerlaufrichtung U₀ bzw. in Kurzschlussrichtung I_{K}. Diese Verstellung kann beispielsweise durch eine Impedanzänderung des Wechselrichters 3 in Richtung erhöhter bzw. verringerter Impedanz erfolgen.

Ob zunächst eine Verstellung der Leistungführung MPP in Leerlaufrichtung U₀ oder in Kurzschlussrichtung Iₖ erfolgt, kann bei ausreichend sensitiver Sensorik gemäß einer anhand der Daten des Sensor 7 bereits bestimmbaren Wahrscheinlichkeit für einen seriellen oder für einen parallelen Lichtbogen erfolgen. In diesem Fall wird beispielsweise bei einem mit größerer Wahrscheinlichkeit vorbestimmten seriellen Lichtbogen die Leistungsführung gezielt in Leerlaufrichtung U₀ verstellt. In Folge dessen wird eine Leistungsabnahme des Lichtbogens erwartet. Tritt eine solche Leistungsabnahme des Lichtbogens ein, so wird zuverlässig auf einen seriellen Lichtbogen erkannt. Anderenfalls, wenn keine Leistungsänderung oder sogar eine Leistungszunahme des Lichtbogens sensiert wird, wird die Leistungsführung um den Verstellbetrag ΔP_{U0} zurückgestellt. Anschließend erfolgt eine Verstellung der Leistungsführung MPP um den Verstellbetrag ΔP_{Ik} in Kurzschlussrichtung Iₖ. Wird daraufhin eine Leistungsabnahme des Lichtbogens detektiert, so wird zuverlässig auf einen parallelen Lichtbogen erkannt und die entsprechende Sicherschaltung der Anlage 1 initiiert, indem die Steuerung 9 das Schließen des Kurzschlussschalters 13 veranlasst.

Ist demgegenüber aus dem Sensorsignal des Sensors 7 mit größerer Wahrscheinlichkeit ein paralleler Lichtbogen klassifizierbar, so veranlasst die Steuerung zunächst eine Verstellung der Leistungsführung MPP um den Verstellbetrag ΔP_{Ik} in Kurzschlussrichtung Iₖ. In diesem Fall wird beispielsweise bei einem mit größerer Wahrscheinlichkeit vorbestimmten parallelen Lichtbogen die Leistungsführung gezielt in Kurzschlussrichtung Iₖ verstellt. In Folge dessen wird wiederum eine Leistungsabnahme des Lichtbogens erwartet. Tritt eine solche Leistungsabnahme des Lichtbogens ein, so wird zuverlässig auf einen parallelen Lichtbogen erkannt. Anderenfalls, wenn keine Leistungsänderung oder sogar eine Leistungszunahme des Lichtbogens sensiert wird, wird die Leistungsführung um den Verstellbetrag ΔP_{Ik} zurückgestellt. Anschließend erfolgt eine Verstellung der Leistungsführung MPP um den Verstellbetrag ΔP_{U0} in Leerlaufrichtung U₀. Wird daraufhin eine Leistungsabnahme des Lichtbogens detektiert, so wird zuverlässig auf einen seriellen Lichtbogen erkannt und die entsprechende Sicherschaltung der Anlage 1 initiiert, indem die Steuerung 9 das Öffnen des Trennschalters 11 veranlasst.

Analog zu einer solchen Verstellung der Leistungsführung in die Leerlauf- bzw. Kurzschlussrichtung ist auch eine entsprechende Impedanzerhöhung bzw. -verringerung des Wechselrichters 3 ausgehend vom jeweils aktuellen Arbeitspunkt des Wechselrichters 3.

Treten an Stelle vergleichsweise langzeitig brennender Lichtbögen eine Folge von vergleichsweise kurzzeitig brennenden Lichtbögen auf, beispielsweise aufgrund von Vibrationen, so kann die Leistungsanalyse oder Verlöschungsüberprüfung auf die Folgen der Lichtbögen erweitert werden. Hierzu wird überprüft, ob mit den entsprechenden Leistungsverstellungen bzw. Impedanzveränderungen lediglich Lichtbögen geringer Leistung auftreten, oder ob Neuzündungen von Lichtbögen verhindert werden.

Sind in einer größeren Anlage 1 mehrere Lichtbogensensoren lediglich in den Strings Sₙ oder auch in den Strings Sₙ und in der Sammelleitung eingesetzt, und kann darüber hinaus ein auftretender Lichtbogen zuverlässig einem String Sₙ zugeordnet werden, so kann bei erkanntem seriellen Lichtbogen an Stelle des Trennschalters 11 auch ein gegebenenfalls vorhandener Stringtrenner geöffnet werden. Ist jedoch keine eindeutige Stringfestlegung möglich oder wird der Lichtbogen in der Haupt- oder Zuleitung 5 detektiert, so wird das erfindungsgemäße Verfahren, also eine Verstellung der Leistungsführung in die Leerlaufrichtung U₀ und/oder in die Kurzschlussrichtung Iₖ durchgeführt.

Die Anlage 1 kann allgemein eine Gleichspannungsanlage mit einem beispielsweise aus einer Anzahl von einzelnen Gleichstromerzeugern bestehenden Gleichstromgenerator für höhere Gleichspannungen (ca. 1000V) sein. Den Wechselrichters 3 bildet dann allgemein ein Wandler (DC-DC-Wandler, AC-DC-Wandler, Laderegler oder dergleichen) mit Impedanzregelung/-steuerung bzw. Leistungsführung.

### Bezugszeichenliste

- 1: Gleichstrom-/Photovoltaikanlage
- 2: Modul
- 3: Wechselrichter/Wandler
- 4: öffentliches Netz
- 5: Zuleitung
- 6: Gleichstrom-/Photovoltaikgenerator
- 7: Lichtbogensensor
- 8: Signalleitung
- 9: Steuerung
- 10: Steuerleitung
- 11: Trennschalter
- 12: Steuerleitung
- 13: Kurzschlussschalter

- A - D: serieller Lichtbogen
- E,F: paralleler Lichtbogen
- Sn: String

## Patentansprüche

1. Verfahren zum sicheren Schalten einer Gleichspannungsanlage (1), insbesondere einer Photovoltaikanlage, im Falle eines gleichstromseitig auftretenden Lichtbogens, bei dem der generierte Gleichstrom und die erzeugte Gleichspannung hinsichtlich einer Leistungsführung eingestellt werden, wobei bei einem seriellen Lichtbogen eine Gleichstromunterbrechung und bei einem parallelen Lichtbogen ein Kurzschlussstrom erzeugt wird,
**dadurch gekennzeichnet,**
**dass** im Falle eines sensorisch erfassten Lichtbogens die Leistungsführung (MPP) verstellt und eine Leistungsänderung des Lichtbogens erfasst wird, wobei im Falle einer Leistungsabnahme des Lichtbogens in Abhängigkeit von der Verstellrichtung (ΔP_{Uo},ΔP_{Ik}) der Leistungsführung (MPP) auf einen seriellen oder auf einen parallelen Lichtbogen erkannt wird.

2. Verfahren nach Anspruch 1,
**dadurch gekennzeichnet,**
**dass** die Leistungsführung (MPP) in Leerlaufrichtung (U₀) um einen Verstellbetrag (ΔP_{Uo}) verstellt und eine Leistungsänderung des Lichtbogens erfasst wird, wobei im Falle einer Leistungsabnahme des Lichtbogens auf einen seriellen Lichtbogens erkannt wird, und wobei im Falle keiner Leistungsänderung oder einer Leistungszunahme des Lichtbogens die Leistungsführung (MPP) um den Verstellbetrag (ΔP_{Uo}) zurückgestellt wird.

3. Verfahren nach Anspruch 2,
**dadurch gekennzeichnet,**
**dass** im Falle keiner Leistungsänderung bzw. einer Leistungszunahme des Lichtbogens dieser als paralleler Lichtbogen klassifiziert wird.

4. Verfahren nach Anspruch 1,
**dadurch gekennzeichnet,**
**dass** die Leistungsführung (MPP) in Kurzschlussrichtung (Iₖ) um einen Verstellbetrag (ΔP_{Ik}) verstellt und eine Leistungsänderung des Lichtbogens erfasst wird, wobei im Falle einer Leistungsabnahme des Lichtbogens auf einen parallelen Lichtbogens erkannt wird, und wobei im Falle keiner Leistungsänderung oder einer Leistungszunahme des Lichtbogens die Leistungsführung (MPP) um den Verstellbetrag (ΔP_{Ik}) zurückgestellt wird.

5. Verfahren nach Anspruch 4,
**dadurch gekennzeichnet,**
**dass** im Falle keiner Leistungsänderung bzw. einer Leistungszunahme des Lichtbogens dieser als serieller Lichtbogen klassifiziert wird.

6. Vorrichtung zum sicheren Schalten einer Gleichspannungsanlage (1), mit einem Wandler (3) und mit einer Steuerung (9) zur Leistungsführung (MPP), wobei dem Wandler (3) gleichstromseitig ein Lichtbogensensor (7) vorgeschaltet ist, der mit der Steuerung (9) verbunden ist, und wobei die Steuerung (9) bei einer Klassifizierung als serieller Lichtbogen eine gleichstromseitige Trennung und bei einer Klassifizierung als paralleler Lichtbogen ein gleichstromseitiges Kurzschließen des Wandlers (3) bewirkt,
**dadurch gekennzeichnet,**
- **dass** im Falle eines sensorisch erfassten Lichtbogens mittels der Steuerung (9) eine Verstellung der Leistungsführung (MPP) erfolgt, und
- **dass** die Steuerung (9) anhand einer erfassten Leistungsänderung des Lichtbogens und in Abhängigkeit von der Verstellrichtung (ΔP_{Uo}, ΔP_{Ik}) der Leistungsführung (MPP) den Lichtbogen klassifiziert.

7. Vorrichtung nach Anspruch 6,
**dadurch gekennzeichnet,**
**dass** die Steuerung (9) ausgangsseitig mit einem dem Wandler (3) seriell vorgeschalteten Trennschalter (11) und mit einem dem Wandler (3) parallel geschalteten Kurzschlussschalter (13) verbunden ist, wobei die Steuerung (9) bei im Falle eines seriellen Lichtbogens den Trennschalter (11) in dessen Offenstellung und im Falle eines parallelen Lichtbogens den Kurzschlussschalter (13) in dessen Schließstellung steuert.

8. Vorrichtung nach Anspruch 6 oder 7,
**dadurch gekennzeichnet,**
**dass** zur Verstellung der Leistungsführung (MPP) eine Änderung der Impedanz des Wandlers (3) erfolgt.

9. Vorrichtung nach einem der Ansprüche 6 bis 8,
**dadurch gekennzeichnet,**
**dass** der Wandler (3) ein Wechselrichter, ein DC-DC-Wandler oder ein Laderegler ist.

10. Photovoltaikanlage (1) mit einer Vorrichtung nach einem der Ansprüche 6 bis 9.

## Claims

1. Method for the safe switching of a DC voltage system (1), in particular a photovoltaic system, in the event of a DC-side arc, in which the generated direct current and the DC voltage produced are adjusted with respect to output management, wherein a DC interruption is produced in the event of a serial arc and a short circuit current is produced in the event of a parallel arc,
**characterised in that**,
in the event of an arc recorded by a sensor, output management (MPP) is shifted and a power change of the arc is recorded, wherein, in the event of a power reduction of the arc, a serial or parallel arc is detected on the basis of the adjustment direction (ΔP_{Uo}, ΔP_{IK}) of output management (MPP).

2. Method according to claim 1,
**characterised in that**
output management (MPP) is shifted by an adjustment amount (ΔP_{Uo}) in the idle direction (U₀) and a power change of the arc is recorded, wherein a serial arc is detected in the event of a power reduction of the arc, and wherein in the event of no power change or a power increase of the arc, output management (MPP) is reset by the adjustment amount (ΔP_{Uo}).

3. Method according to claim 2,
**characterised in that**
in the event of no power change or a power increase of the arc, the arc is classified as a parallel arc.

4. Method according to claim 1,
**characterised in that**
output management (MPP) is shifted by an adjustment amount (ΔP_{IK}) in the short circuit direction (Iₖ) and a power change of the arc is recorded, wherein a parallel arc is detected in the event of a power reduction of the arc, and wherein in the event of no power change or a power increase of the arc, output management (MPP) is reset by the adjustment amount (ΔP_{IK}).

5. Method according to claim 4,
**characterised in that**
in the event of no power change or a power increase of the arc, the arc is classified as a serial arc.

6. Device for the safe switching of a DC voltage system (1), having a converter (3) and having a control system (9) for output management (MPP), wherein an arc sensor (7) is upstream of the converter (3) on the DC side, said arc sensor (7) being connected to the control system (9), and wherein the control system (9) causes a DC-side separation in the event of classification as a serial arc and causes a DC-side short circuiting of the converter (3) in the event of a classification as a parallel arc,
**characterised in that**
- in the event of an arc detected by a sensor, a shifting of output management (MPP) takes place by means of the control system (9), and
- the control system (9) classifies the arc by means of a recorded power change of the arc and depending on the adjustment direction (ΔP_{Uo}, ΔP_{IK}) of output management (MPP).

7. Device according to claim 6,
**characterised in that**
the control device (9) is connected on the output side to a circuit breaker (11) which is connected in series upstream from the converter (3) and to a short-circuit switch (13) which is connected in parallel to the converter (3), wherein the control device (9) controls the circuit breaker (11) in its open position in the event of a serial arc and the short-circuit switch (13) in its closed position in the event of a parallel arc.

8. Device according to claim 6 or 7,
**characterised in that**
a change of the impedance of the converter (3) takes place for the adjustment of output management (MPP).

9. Device according to one of claims 6 to 8,
**characterised in that**
the converter (3) is an inverter, a DC-DC converter or a charge controller.

10. Photovoltaic system (1) having a device according to one of claims 6 to 9.

## Revendications

1. Procédé pour assurer une commutation sûre d'une installation à courant continu (1), notamment une installation photovoltaïque, dans le cas de l'apparition d'un arc électrique du côté courant continu, d'après lequel le courant continu engendré et la tension continue produite sont réglés eu égard à un suivi de puissance, et, dans le cas d'un arc électrique série, on produit une interruption du courant continu, et dans le cas d'un arc électrique parallèle, on produit un courant de court-circuit,
**caractérisé**
**en ce que** dans le cas d'un arc électrique relevé par détecteur, on produit un déplacement du suivi de puissance (MPP ou PPM pour point de puissance maximale) et on relève une variation de puissance de l'arc électrique, et dans le cas d'une diminution de puissance de l'arc électrique, il est possible d'en déduire un arc électrique série ou parallèle en fonction de la direction de déplacement (ΔP_{U0}, ΔP_{IK}) du suivi de puissance (MPP).

2. Procédé selon la revendication 1,
**caractérisé**
**en ce que** l'on déplace le suivi de puissance (MPP) dans la direction de marche à vide (U₀) d'une valeur de déplacement (ΔP_{U0}), et l'on relève une variation de puissance de l'arc électrique, et dans le cas d'une diminution de puissance de l'arc électrique, on en déduit un arc électrique série, et dans le cas où il ne se produit pas de variation de puissance ou une augmentation de puissance de l'arc électrique, on ramène le suivi de puissance (MPP) d'une valeur correspondant à la valeur de déplacement (ΔP_{U0}).

3. Procédé selon la revendication 2,
**caractérisé**
**en ce que** dans le cas où il ne se produit pas de variation de puissance ou respectivement une augmentation de puissance de l'arc électrique, celui-ci est classé comme étant un arc électrique parallèle.

4. Procédé selon la revendication 1,
**caractérisé**
**en ce que** l'on déplace le suivi de puissance (MPP) dans la direction de court-circuit (I_{K}) d'une valeur de déplacement (ΔP_{IK}), et l'on relève une variation de puissance de l'arc électrique, et dans le cas d'une diminution de puissance de l'arc électrique, on en déduit un arc électrique parallèle, et dans le cas où il ne se produit pas de variation de puissance ou une augmentation de puissance de l'arc électrique, on ramène le suivi de puissance (MPP) d'une valeur correspondant à la valeur de déplacement (ΔP_{IK}).

5. Procédé selon la revendication 4,
**caractérisé**
**en ce que** dans le cas où il ne se produit pas de variation de puissance ou respectivement une augmentation de puissance de l'arc électrique, celui-ci est classé comme étant un arc électrique série.

6. Dispositif pour assurer une commutation sûre d'une installation à courant continu (1), comprenant un convertisseur (3) et une commande (9) pour le suivi de puissance (MPP), le convertisseur (3) étant précédé, côté courant continu, d'un détecteur d'arc électrique (7), qui est relié à la commande (9), et la commande (9) produisant, dans le cas d'une classification en tant qu'arc électrique série, un isolement côté courant continu, et dans le cas d'une classification en tant qu'arc électrique parallèle, une mise en court-circuit côté courant continu, du convertisseur (3),
**caractérisé**
- **en ce que** dans le cas où un arc électrique est relevé par détecteur, la commande (9) effectue un déplacement du suivi de puissance (MPP), et
- **en ce que** la commande (9) assure la classification de l'arc électrique au regard d'une variation de puissance relevée de l'arc électrique et en fonction de la direction de déplacement (ΔP_{U0}, ΔP_{IK}) du suivi de puissance (MPP).

7. Dispositif selon la revendication 6,
**caractérisé**
**en ce que** la commande (9) est reliée, côté sortie, à un commutateur d'isolement ou de sectionnement (11) monté en série et en amont du convertisseur (3), et à un commutateur de court-circuit (13) monté en parallèle avec le convertisseur (3), la commande (9) assurant, dans le cas d'un arc électrique série, la commande du commutateur d'isolement (11) dans sa position ouverte, et, dans le cas d'un arc électrique parallèle, la commande du commutateur de court-circuit (13) dans sa position de fermeture.

8. Dispositif selon la revendication 6 ou la revendication 7,
**caractérisé**
**en ce que** pour produire un déplacement de réglage du suivi de puissance (MPP), on effectue une variation de l'impédance du convertisseur (3).

9. Dispositif selon l'une des revendications 6 à 8,
**caractérisé**
**en ce que** le convertisseur (3) est un onduleur, un convertisseur DC-DC ou un régulateur de charge.

10. Installation photovoltaïque (1) comprenant un dispositif selon l'une des revendications 6 à 9.
